# EUROPEAN PATENT APPLICATION

(11) **EP 4 679 113 A1**
(43) Date of publication of application: **14.01.2026**
(21) Application number: 24187293.6
(22) Date of filing: 09.07.2024
(51) Int. Cl.: G01R 31/389, G01R 31/392, G01R 31/396, G01R 31/64, H01M 10/42, H02J 3/32, H02J 7/00, H02M 7/483

(54) **METHOD FOR DETERMINING A STATE OF HEALTH, SOH, OF AN ENERGY STORAGE MODULE, A CONTROL UNIT AND AN ARRANGEMENT**

(71) Applicant: Hitachi Energy Ltd, 8050 Zürich (CH)
(72) Inventor: Bai, Haofeng, 72348 Västerås (SE); Zhang, Hongyang, 11524 Stockholm (SE); Noisette, Philippe, 1228 Plan-les-Ouates (CH); WU, Runlin, 11415 Stockholm (SE)
(74) Representative: AWA Sweden AB

(57) **Abstract**

There is disclosed herein a method for determining SoH of an energy storage module (22) of an energy storage system (20) of an arrangement (1). The energy storage system is connected to an alternating current, AC, power grid (2) through a multilevel modular converter, MMC (10) of the arrangement. The method comprises controlling the MMC to generate a circulating current with a pulse pattern having different levels and that circulates through the energy storage modules, measuring a module voltage over and a module current through each energy storage module, determining an individual module resistance for each energy storage module based on the respective module voltage and the respective module current at the different levels in the pulse pattern, and determining a SoH for each energy storage module based on the individual module resistance. There is further disclosed herein a control unit (50) and an arrangement.

## Description

### Technical field

The present disclosure relates to a method for determining state of health, SoH, of an energy storage module of an energy storage system. The present disclosure further relates to a control unit and an arrangement.

### Background

The ongoing electrification of various sectors, such as transportation and heating, together with the demand for fossil-free energy sources, such as wind energy and solar energy, leads to a more complex power system with a higher demand for energy. The fossil-free energy sources are often intermittent. Therefore, to balance the supply and demand, energy storage systems are implemented in the power system at a larger scale. To meet such a high energy demand, energy storage modules are connected in series and parallel to fulfill the voltage and current requirements.

State of Health (SoH) is a metric used to assess the condition of energy storage modules within an energy storage system. It provides a quantitative measure of an energy storage module current performance relative to its optimal or original state. SoH considers factors such as capacity, internal resistance, and self-discharge rate to determine the remaining useful life and efficiency of the energy storage module. This metric is essential for optimizing the performance, safety, and longevity of the energy storage system, enabling informed decisions regarding maintenance, replacements, and operational strategies. Accurate SoH monitoring ensures the reliable and efficient operation of energy storage systems.

Electrical impedance spectrum is a known method used to check the SoH of the energy storage system, meaning that the electrical impedance is measured to identify the SoH of the energy storage system. In order to do that, an AC current is generated by a modular multi-level converter that flows through the energy storage elements. However, the existing method for measuring SoH is used for measuring SoH in the energy storage system as a whole and it requires additional sensors for measuring the SoH at energy storage module level. This increases the cost and complexity of the energy storage system. Therefore, a less complex method for measuring the SoH of the energy storage modules is required.

### Summary

In view of the above, it is an object of the present disclosure to provide a method for determining state of health, SoH, of an energy storage module of an energy storage system.

It is also an object of the present disclosure to provide a less complex energy storage system which determines the SoH of the energy storage modules.

A further object of the present disclosure is to provide an energy storage system with improved performance and efficiency.

To achieve at least one of the above objects, and also other objects that will be evident from the following description, a method defined in claim 1 is provided according to the present disclosure. Preferred variants of the energy storage segment will be evident from the dependent claims.

More specifically, there is provided, according to a first aspect of the present disclosure a method for determining a state of health, SoH, of an energy storage module of an energy storage system of an arrangement. The arrangement comprises a multilevel modular converter, MMC, having an alternating current, AC, side and a direct current, DC, side including a first DC pole and a second DC pole, the MMC being connected with an AC power grid on its AC side. The energy storage system comprises at least one string having a plurality of energy storage modules, wherein said at least one string is connected between the first DC pole and the second DC pole. The method comprises controlling the MMC to generate a circulating current with a pulse pattern having different levels and that circulates through the energy storage modules, measuring a module voltage over and a module current through each energy storage module caused by the circulating current, determining an individual module resistance for each energy storage module based on the respective module voltage and the respective module current at the different levels in the pulse pattern, and determining a SoH for each energy storage module based on the individual module resistance.

According to a second aspect of the present disclosure a control unit for determining a state of health, SoH, of an energy storage module of an energy storage system of an arrangement is provided. The arrangement comprises a multilevel modular converter, MMC, having an alternating current, AC, side and a direct current, DC, side including a first DC pole and a second DC pole, the MMC being connectable with an AC power grid on its AC side. The energy storage system comprises at least one string having a plurality of energy storage modules, wherein said at least one string is connected between the first DC pole and the second DC pole The control unit is configured to control the MMC to generate a circulating current with a pulse pattern having different levels and that circulates through the energy storage modules, measure a module voltage over and a module current through each energy storage module caused by the circulating current, determine an individual module resistance for each energy storage module based on the respective module voltage and the respective module current at the different levels in the pulse pattern, and determine a SoH for each energy storage module based on the individual module resistance.

According to a third aspect of the present disclosure an arrangement which is connectable to an alternating current, AC, power grid is provided. The arrangement comprises a multilevel modular converter, MMC, having an AC side and a direct current, DC, side including a first DC pole and a second DC pole, the MMC being connectable with the AC power grid on its AC side, and an energy storage system comprising at least one string having a plurality of energy storage modules, wherein said at least one string is connected between the first DC pole and the second DC pole. The grid-connected energy storage system further comprises a control unit according to the second aspect.

The provided method is advantageous as the energy storage module through its electronics are able to measure the circulating current with the pulse pattern having different levels and based on these measurements, the SoH of the respective energy storage module can be determined. The method provides a way of measuring the SoH on energy storage module level. The module voltage and module current are measured for the different levels of the circulating current and based on these measurements, an individual module resistance can be determined for each energy storage module at each level of the circulating current. The individual module resistance can be used to determine the SoH of the energy storage module. This allows the SoH of the energy storage module to be determined without adding additional sensors for measuring. The already existing electronics of the energy storage module are able to perform these measurements.

In conventional methods, such as the electrical impedance spectrum, the circulating current is generated at frequencies which are not possible to measure with the existing electronics of the energy storage modules. Therefore, the conventional method generally only measures the SoH of the energy storage system and requires additional sensors for measuring the SoH at energy storage module level, while the provided method allows for measuring the SoH on energy storage module level without an increase of sensors needed for the measurements. In the conventional methods, frequency information is required to calculate the impedance. In the conventional method using an electrical impedance spectrum, the impedance is determined by dividing the voltage over the current at different frequencies. The sampling frequency of the electronics in the energy storage modules are usually not able to sample waveform with a frequency over the fundamental frequency, due to the low Nyquist frequency. However, with the provided method, no frequency information is needed and therefore the limitation from the Nyquist frequency may be neglected. The provided method calculates the individual module resistance, which does not require any frequency information, and as no frequency information is needed the combination of a low sampling frequency with high frequency harmonics is possible for the provided method. The individual module resistance dependency on frequency is low compared to the impedance. Therefore, the relationship between the voltage and the current can be represented without frequency information. Thereby, a frequency may be used that does not affect the active power flow towards the grid and still SoH on energy storage module level may be determined. The existing electronics of the energy storage modules may be referred to that each energy storage module may comprise module electronics devices for measuring the module voltage and the module current. These module electronic devices are normally included in the energy storage module.

It is advantageous to determine and monitor the SoH on energy storage module level as this allows for detecting how close an energy storage module is to end of life. This increases the possibilities to schedule the maintenance and reduces the risk of unexpected failures. Further, by monitoring the SoH of an energy storage module, abnormal aging and fault may also be detected. These advantages results in that the reliability and the availability of the grid-connected energy storage system are improved.

Further, by determining the SoH in each energy storage module, also the SoH of each string may be determined as well. This may for example be an average of the SoH of the energy storage modules in the string.

The MMC can be controlled to generate a circulating current with a pulse pattern in addition to managing the ordinary exchange of active power and reactive power between the power grid on the AC side and the energy storage system on the DC side. The circulating current circulates through the energy storage system such that the circulating current travels through the energy storage modules. This result in a module voltage and a module current in each energy storage module which can be measured. By measuring the module voltage and the module current at different levels of the pulse pattern, the individual module resistance can be determined. From the individual module resistance, the SoH of the respective energy storage module can be determined.

The pulse pattern may be fixed. However, an unfixed pulse pattern may also be used.

The pulse pattern is described to have different levels. This may also be referred to as different amplitudes. This implies that the circulating current has at least two different states, i.e. that the amplitude of the circulating current changes over time.

The module voltage and the module current are different for each energy storage module depending on the SoH. Degraded energy storage modules may have higher internal resistance and lower capacity. A decrease in SoH is expected based on the aging of the energy storage module. Aging of an energy storage module refers to the gradual decline in its performance and capacity due to various factors. Each charge-discharge cycle contributes to this degradation, known as cycle life aging. Even when not in use, chemical reactions within the energy storage module may lead to calendar aging. High temperatures accelerate these aging processes, while extreme temperatures cause additional stress. Frequent deep discharges or using most of the module's capacity in each cycle, can also speed up aging, as can operating the module at high charge and discharge rates, which generate more heat and stress the internal components.

The circulating current may comprise at least first pulses having a first pulse level and second pulses having a second pulse level, providing the different levels of the pulse pattern. The first pulse level and the second pulse level are different. With at least two fixed pulse levels, the determination of the individual module resistance is facilitated. This provides two different measurements of the module current and the module voltage which may be used to determine the individual module resistance and thereby the SoH.

The determination of the individual module resistance may be based on differences between at least one first measurement of the module voltage and the module current at the first pulse level and at least one second measurement of the module voltage and the module current at the second pulse level.

The measurements at the first pulse level and second pulse level will produce different values for the module voltage and the module current. Using the differences between these values, the individual module resistance may be determined. As earlier discussed, due to the first pulse level and the second pulse level, the method is not dependent on the frequency to determine the individual module resistance and thereby the SoH. By comparing the difference of the module voltage at the first pulse level and the module voltage at the second pulse level and comparing the difference of the module current at the first pulse level and the module current at the second pulse level, the method is not dependent on the ability of the energy storage module to measure high frequencies. If the pulse pattern of the circulating current is repeated, a plurality of measurements at each of the first pulse level and the second pulse level may be used. In this case, an average of the module voltage at the first pulse level and an average of the module voltage at the second pulse level may be used to determine the difference in module voltage at the first pulse level and at the second pulse level. Similarly, an average of the module current at the first pulse level and an average of the module current at the second pulse level may be used to determine the difference in module current at the first pulse level and at the second pulse level.

As an example the first pulse level may be +5 A and the second pulse level may be -5 A, as another example the first pulse level may be +5 A and the second pulse level may be +10 A.

The determination of the individual module resistance may be performed by dividing a current difference between the module current of the at least one first measurement and the module current of the at least one second measurement with a voltage difference between the module voltage of the at least one first measurement and the module voltage of the at least one second measurement. This may also be referred to as the ramp rate between the first measurement and the second measurement.

The determination of the individual module resistance may be based on a fixed window average of a plurality of first measurements and a plurality of second measurements. If a plurality of first measurements and a plurality of second measurements are provided, the plurality of first measurements may be plotted on a V-I plane and the plurality of second measurements may also be plotted on the V-I plane. In this case the ramp rate between the two areas of the plurality of measurements may be used to determine the individual module resistance.

Using a fixed window average may provide advantages such as noise reduction by smoothing out short-term fluctuations and revealing underlying trends, which aids in trend identification and data analysis. It helps in mitigating the effects of outliers and irregularities in the data, making it easier to interpret and utilize for decision-making purposes in various fields including finance, engineering, and environmental monitoring.

The circulating current may be a periodic square-wave current, or a non-periodic current, combined with closed loop control by the MMC. The square-wave current may ensure that there is a plurality of measurements at each circulating current level. The square shaped wave may alternate between the first pulse amplitude and the second pulse amplitude. This will generate more measurements to use when calculating the fixed window average, thereby providing a more exact determination of the individual module resistance.

The circulating current may be generated in at least one of a harmonic frequency, predetermined frequency or in a frequency range. The circulating current, generated by the MMC, may be generated at a predetermined frequency or in a predetermined frequency range. The predetermined frequency range may be 50 Hz up to several kHz. As an example harmonic frequencies may be used. Using a harmonic frequency it may be avoided that the MMC generates power flow towards the power grid. With a predetermined frequency is meant a set frequency above the fundamental frequency.

The method may further comprise detecting if the energy storage module has reached end of life by comparing the individual module resistance of the energy storage module with an end-of-life reference value.

The method may further comprise detecting a fault in the energy storage module by comparing the individual module resistance of the energy storage module with a fault reference value.

End-of-life reference values and fault reference values may be used to determine if the energy storage module has reached end-of-life, or if there is a fault in the energy storage module. This may facilitate proactive maintenance work of the energy storage system such that energy storage modules that exceeds the reference value may be replaced or bypassed.

It is expected that an energy storage module that are close to end-of-life will have a higher individual module resistance than an energy storage module in the beginning of life. Further, it is expected that a faulty energy storage module has an even higher individual module resistance.

Effects and features of the second and third aspects may be largely analogous to those described above in connection with the first aspect. Embodiments mentioned in relation to the first aspect may be at least largely compatible with the second and third aspects. It is further noted that the present disclosure relates to all possible combinations of features unless explicitly stated otherwise.

A further scope of applicability of the present disclosure will become apparent from the detailed description given below. However, it should be understood that the detailed description and specific examples, while indicating preferred embodiments of the disclosure, are given by way of illustration only, since various changes and modifications within the scope of the disclosure will become apparent to those skilled in the art from this detailed description.

Hence, it is to be understood that the present disclosure is not limited to the particular component parts of the arrangement described or steps of the method described as such arrangement and method may vary. It is also to be understood that the terminology used herein is for purpose of describing particular embodiments only, and is not intended to be limiting.

### Brief description of the drawings

The present disclosure will by way of example be described in more detail with reference to the appended drawings, which show example embodiments of the disclosure.
- Fig. 1: illustrates a grid-connected energy storage system.
- Fig. 2: illustrates a method for determining state of health of an energy storage module.
- Fig. 3: illustrates a pulse pattern with different levels.

### Detailed description

The present disclosure will now be described more fully hereinafter with reference to the accompanying drawings, in which currently preferred embodiments of the disclosure are shown. This disclosure may, however, be embodied in many different forms and should not be construed as limited to the embodiments set forth herein; rather, these embodiments are provided for thoroughness and completeness, and fully convey the scope of the disclosure to the skilled person.

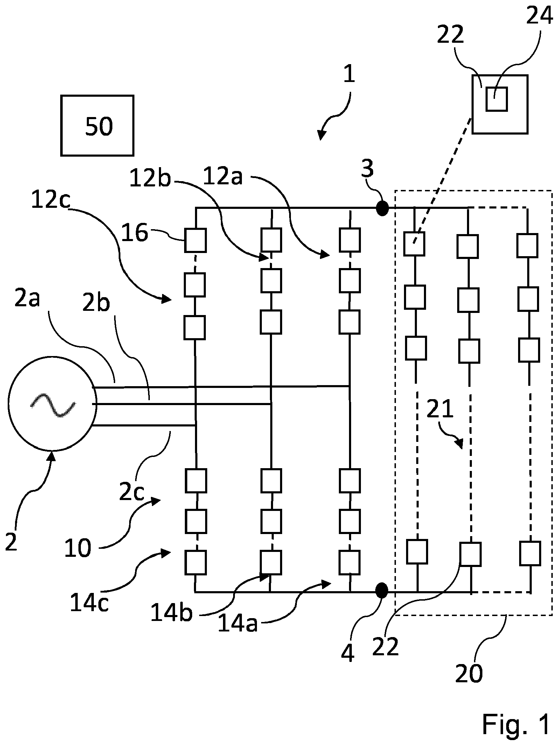

Fig.1 illustrates an arrangement 1 connected to an alternating current, AC, power grid 2. Three connection lines 2a-2c corresponding to the three phases of the AC power grid 2 are connected to a modular multilevel converter, MMC, 10 of the arrangement 1 at an AC side of the MMC 10. The DC side of the MMC 10 comprises a first terminal 3 and a second terminal 4. Each of the connection lines 2a-2c for the three phases is connected to an upper arm 12a-12c and a lower arm 14a-14c of the MMC 10. Each of the upper arms 12a-12c is connected to the first terminal 3 and each of the lower arms 14a-14c is connected to the second terminal 4. The first terminal 3 may be seen as a first DC pole and the second terminal 4 may be seen as a second DC pole. Each arm 12a-12c, 14a-14c comprises a plurality of converter cells 16. The plurality of converter cells 16 performs switching operations to convert an incoming power/voltage between AC and DC. In Fig. 1 an YY-MMC is illustrated. However, it should be noted that other MMC configurations are equally applicable.

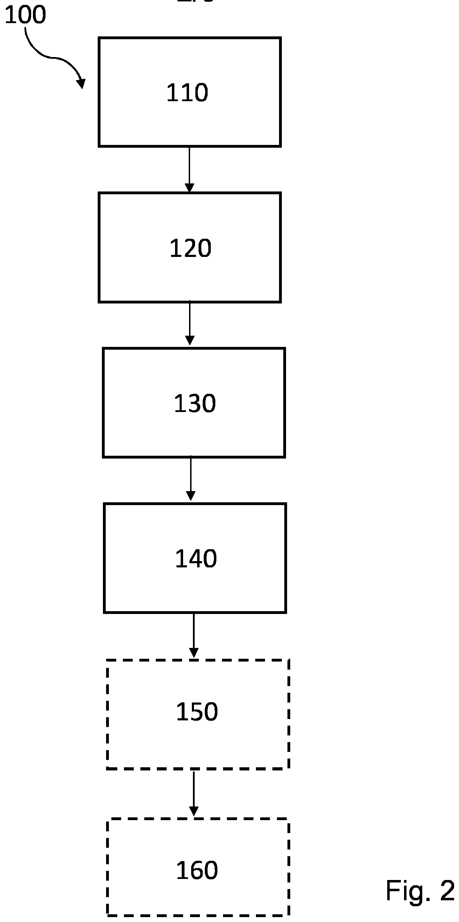

In Fig. 1, the arrangement 1 further comprises an energy storage system 20 having a plurality of strings 21 connected in parallel to the MMC 10 and in parallel to each other between the first terminal 3 and the second terminal 4. Fig. 1 discloses three strings 21. However, as illustrated by the dotted lines, there may be a higher number of strings, which are not shown in Fig. 1. However, the method 100 that will be described in connection to Fig. 2 is equally applicable to an energy storage system 20 with only one string 21. All the dotted lines in the figures represents that more components of the same type may be added in between. Hence, the dotted lines also illustrate that an energy storage string may include more energy storage modules 22 than what is represented in Fig. 1. Each of said plurality of strings 21 comprises a plurality of energy storage modules 22 connected in series. By alternating the number of strings 21 connected in parallel and the number of energy storage modules 22 connected in series, the energy storage system 20 may be designed with different voltage rating and current rating. In the enlarged view of the energy storage module 22, it is illustrated that each energy storage module 22 comprises module electronics devices 24 for measuring a module voltage and a module current.

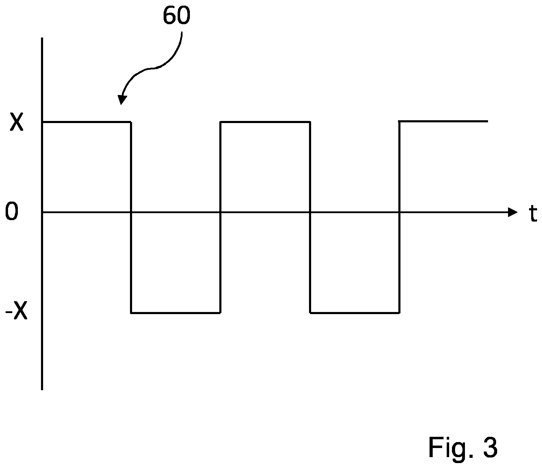

The arrangement 1 comprises a control unit 50 configured to control the power flow of the MMC 10, more specifically by controlling the converter cells 16. Thereby, the control unit 50 controls how much power that is exchanged between arrangement 1 and the AC power grid 2. The control unit 50 is further configured to perform a method for determining a state of health, SoH, of the energy storage modules 22. The method 100 will be further described in connection to Fig. 2 and 3.

In Fig. 2 a method 100 for determining the SoH of an energy storage module 22 of an energy storage system 20 of an arrangement 1 is illustrated. The arrangement 1 and the energy storage system 20 may be designed as described in connection to Fig. 1. The method 100 is configured to operate in an energy storage system 1 comprising at least one string 21 of energy storage modules 22. The energy storage system 20 is arranged on a DC side of the MMC 10 and connected through the MMC to an AC side.

The method 100 comprises controlling 110 the MMC 10 to generate a circulating current with a pulse pattern having different levels and that circulates through the energy storage modules 22. The MMC 10 can be controlled to generate a circulating current with a pulse pattern in addition to managing the ordinary exchange of active power and reactive power between the AC power grid 2 at the AC side and the energy storage system 20 at the DC side. The circulating current circulates through the energy storage system 20 such that the circulating current travels through all the at least one string 21 and thereby all the energy storage modules 22. The pulse pattern may be fixed. However, an unfixed pulse pattern may also be used. The pulse pattern is described to have different levels. This may also be referred to as different amplitudes. This implies that the circulating current has at least two different states, i.e. that the amplitude of the circulating current changes over time.

The circulating current may comprise at least first pulses having a first pulse level and second pulses having a second pulse level, providing the different levels of the pulse pattern. The first pulse level and the second pulse level are different from each other. The circulating current may be shaped as a periodic square-wave to allow the first pulse level and the second pulse level to reoccur periodically. To avoid that the generated circulating current affect the power flow from the MMC 10 towards the AC power grid 2, a predetermined frequency may be used which is higher than the fundamental frequency of the AC power grid 2. As an example a harmonic frequency may be used.

The method 100 further comprises measuring 120 a module voltage over and a module current through each energy storage module 22 caused by the circulating current. The circulating current results in a module voltage and a module current in each energy storage module 22 which can be measured. By measuring the module voltage and the module current at different levels of the pulse pattern, two different module voltages and module currents are obtained. In other words, the measurements at the first pulse level and second pulse level will produce different values for the module voltage and the module current. The already existing electronics of the energy storage module 22 are able to perform these measurements.

If a square-wave current is used, this may ensure that there is a plurality of measurements at each circulating current level. The square shaped wave may alternate between the first pulse amplitude and the second pulse amplitude. This will generate more measurements which may be used to calculate a fixed window average of the first measurement and the second measurement.

The method 100 further comprises determining 130 an individual module resistance for each energy storage module 22 based on the respective module voltage and the respective module current at the different levels in the pulse pattern.

The determination of the individual module resistance may be based on differences between at least one first measurement of the module voltage and of the module current at the first pulse level and at least one second measurement of the module voltage and of the module current at the second pulse level.

To improve the accuracy of the individual module resistance, the determination of the individual module resistance may be based on a fixed window average of a plurality of first measurements and a plurality of second measurements. If a plurality of first measurements and a plurality of second measurements are provided, the plurality of first measurements may also be plotted on a V-I plane and the plurality of second measurements may also be plotted on the V-I plane. In this case the ramp rate between the two areas of the plurality of measurements may be used to determine the individual module resistance.

The ramp rate, i.e. the individual module resistance, may also be calculated by dividing a current difference between the module current of the at least one first measurement and the module current of the at least one second measurement with a voltage difference between the module voltage of the at least one first measurement and the module voltage of the at least one second measurement.

The method 100 further comprises determining 140 a SoH for each energy storage module 22 based on the individual module resistance. The module voltage and the module current are different for energy storage module depending on the SoH. Degraded energy storage modules may have higher internal resistance and lower capacity. A decrease in SoH is expected based on the aging of the energy storage module. Aging of an energy storage module refers to the gradual decline in its performance and capacity due to various factors. Thereby, the SoH can be determined from the module current and the module voltage by calculating the individual module resistance.

The method 100 may further comprise detecting 150 if the energy storage module 22 has reached end of life by comparing the individual resistance of the energy storage module with an end-of-life reference value.

The method 100 may further comprise detecting 160 a fault in the energy storage module 22 by comparing the individual resistance of the energy storage module with a fault reference value.

These two steps are illustrated as dotted boxes, which indicates that the steps are optional.

End-of-life reference values and fault reference values may be used to determine if the energy storage module 22 has reached end-of-life, or if there is a fault in the energy storage module 22.

In Fig. 3, an example of a circulating current with a pulse pattern 60 having different levels is shown. The pulse pattern 60 is square-shaped and has a first level X and a second level -X. The pulse pattern 60 varies over time t such that the pulse pattern 60 shifts between the first level X and the second level -X. The first level X and the second level -X represents different voltages, which could for example be 5 V and -5 V, or 5 V and 10 V.

The person skilled in the art realizes that the present disclosure by no means is limited to the preferred embodiments described above. On the contrary, many modifications and variations are possible within the scope of the appended claims. Additionally, variations to the disclosed embodiments can be understood and effected by the skilled person in practicing the claimed invention, from a study of the drawings, the disclosure, and the appended claims.

## Claims

1. A method (100) for determining a state of health, SoH, of an energy storage module (22) of an energy storage system (20) of an arrangement (1), which comprises a multilevel modular converter, MMC, having an alternating current, AC, side and a direct current, DC, side including a first DC pole and a second DC pole, the MMC being connected with an AC power grid on its AC side, and
the energy storage system, which comprises at least one string (21) having a plurality of energy storage modules, wherein said at least one string is connected between the first DC pole (3) and the second DC pole (4), the method comprising;
controlling (110) the MMC to generate a circulating current with a pulse pattern having different levels and that circulates through the energy storage modules,
measuring (120) a module voltage over and a module current through each energy storage module caused by the circulating current,
determining (130) an individual module resistance for each energy storage module based on the respective module voltage and the respective module current at the different levels in the pulse pattern, and
determining (140) a SoH for each energy storage module based on the individual module resistance.

2. The method according to claim 1, wherein the circulating current comprises at least first pulses having a first pulse level and second pulses having a second pulse level, providing the different levels of the pulse pattern.

3. The method according to claim 2, wherein the determination of the individual module resistance is based on differences between at least one first measurement of the module voltage and the module current at the first pulse level and at least one second measurement of the module voltage and the module current at the second pulse level.

4. The method according to claim 3, wherein the determination of the individual module resistance is performed by dividing a current difference between the module current of the at least one first measurement and the module current of the at least one second measurement with a voltage difference between the module voltage of the at least one first measurement and the module voltage of the at least one second measurement.

5. The method according to claim 3 or 4, wherein the determination of the individual module resistance is based on a fixed window average of a plurality of first measurements and a plurality of second measurements.

6. The method according to any one of the preceding claims, wherein the circulating current is a periodic square-wave current, or a non-periodic current, combined with closed loop control by the MMC.

7. The method according to any one of the preceding claims, wherein the circulating current is generated in at least one of a harmonic frequency, predetermined frequencies or in a frequency range.

8. The method according to any one of the preceding claims, further comprising detecting (150) if the energy storage module has reached end of life by comparing the individual module resistance of the energy storage module with an end-of-life reference value.

9. The method according to any one of the preceding claims, further comprising detecting (160) a fault in the energy storage module by comparing the individual module resistance of the energy storage module with a fault reference value.

10. A control unit (50) for determining a state of health, SoH, of an energy storage module (22) of an energy storage system (20) of an arrangement (1), which comprises a multilevel modular converter, MMC, (10) having an alternating current, AC, side and a direct current, DC, side including a first DC pole (3) and a second DC pole (4), the MMC being connectable with an AC power grid (2) on its AC side, and
the energy storage system, which comprises at least one string (21) having a plurality of energy storage modules, wherein said at least one string is connected between the first DC pole and the second DC pole,
wherein the control unit is configured to;
control the MMC to generate a circulating current with a pulse pattern having different levels and that circulates through the energy storage modules,
measure a module voltage over and a module current through each energy storage module caused by the circulating current,
determine an individual module resistance for each energy storage module based on the respective module voltage and the respective module current at the different levels in the pulse pattern, and
determine a SoH for each energy storage module based on the individual module resistance.

11. An arrangement (1), which is connectable to an alternating current, AC, power grid (2), comprising:
a multilevel modular converter, MMC, (10) having an AC side and a direct current, DC, side including a first DC pole (3) and a second DC pole (4), the MMC being connectable with the AC power grid on its AC side,
an energy storage system (20) comprising at least one string (21) having a plurality of energy storage modules (22), wherein said at least one string is connected between the first DC pole and the second DC pole,
, and
a control unit (50), wherein the control unit is configured to;
control the MMC to generate a circulating current with a pulse pattern having different levels and that circulates through the energy storage modules,
measure a module voltage over and a module current through each energy storage module caused by the circulating current,
determine an individual module resistance for each energy storage module based on the respective module voltage and the respective module current at the different levels in the pulse pattern, and
determine a SoH for each energy storage module based on the individual module resistance.

12. The arrangement according to claim 11, wherein each energy storage module comprises module electronics devices for measuring the module voltage and the module current.
